# EUROPEAN PATENT APPLICATION

(11) **EP 4 768 626 A1**
(43) Date of publication of application: **01.07.2026**
(21) Application number: 25217589.8
(22) Date of filing: 21.11.2025
(51) Int. Cl.: C23C 16/455, C23C 16/44

(54) **GAS EXHAUST CONDUIT PAIR**

(30) Priority: 05.12.2024 US 202463728465 P
(71) Applicant: ASM IP Holding B.V., 1322 AP Almere (NL)
(72) Inventor: OOSTERLAKEN, Theodorus G.M., 1322 AP Almere (NL); JDIRA, Lucian, 1322 AP Almere (NL); BANKRAS, Radko Gerard, 1322 AP Almere (NL); YUKANANTO, Riza, 1322 AP Almere (NL); PROSERPIO, Davide, 1322 AP Almere (NL); MARTIN, Andrew Tristan, 1322 AP Almere (NL)
(74) Representative: V.O.

(57) **Abstract**

A gas exhaust conduit pair comprising a first gas exhaust conduit and a second gas exhaust conduit is disclosed. The first gas exhaust conduit comprises a first end configured for coupling to a first gas exhaust line; a second, closed end opposite the first end; a first gas exhaust conduit wall extending in a first direction between the first end and the second end and enclosing a first gas conduction channel; and a first set of holes in the first gas exhaust conduit wall. The second gas exhaust conduit comprises a first end configured for coupling to a second gas exhaust line; a second, closed end opposite the first end; a second gas exhaust conduit wall extending the first direction between the first end and the second end and enclosing a second gas conduction channel; and a second set of holes in the second gas exhaust conduit wall. The first set of holes has a different arrangement to the second set of holes.

## Description

### FIELD

The present disclosure relates generally to the field of semiconductor processing methods, and associated structures and apparatus, and to the field of device and integrated circuit manufacture. More particularly the present disclosure generally relates to devices for exhausting gas from a process chamber of a batch semiconductor processing apparatus.

### BACKGROUND

In the field of semiconductor processing apparatus, batch processing tools have advantages over single wafer tools in that many wafers can be processed simultaneously, improving throughput. In processes which involve wafers having a high degree of surface enhancement, a large quantity of precursor gas is required in order to provide a uniform layer on the entire face of a wafer. The precursor flow should be as uniform as possible to avoid variations in amount of precursor deposited on different wafers in the same batch.

The use of multi-hole injectors for providing precursor gases to a process chamber of a batch processing tool, e.g. a vertical furnace, is known and can provide a more uniform distribution of gas along a height of the vertical furnace at the point of injection.

Any discussion, including discussion of problems and solutions, set forth in this section, has been included in this disclosure solely for the purpose of providing a context for the present disclosure, and should not be taken as an admission that any or all of the discussion was known at the time the invention was made or otherwise constitutes prior art.

### BRIEF SUMMARY

This summary introduces a selection of concepts in a simplified form, which are described in further detail below. This summary is not intended to necessarily identify key features or essential features of the claimed subject matter, nor is it intended to be used to limit the scope of the claimed subject matter.

According to a first aspect of the present invention, there is provided a gas exhaust conduit pair comprising a first gas exhaust conduit and a second gas exhaust conduit. The first gas exhaust conduit comprises a first end configured for coupling to a first gas exhaust line; a second end opposite the first end, the second end being closed; a first gas exhaust conduit wall extending in a first direction between the first end and the second end and enclosing a first gas conduction channel; and a first set of holes in the first gas exhaust conduit wall. The second gas exhaust conduit comprises a first end configured for coupling to a second gas exhaust line; a second end opposite the first end, the second end being closed; a second gas exhaust conduit wall extending the first direction between the first end and the second end and enclosing a second gas conduction channel; and a second set of holes in the second gas exhaust conduit wall. The first set of holes has a different arrangement to the second set of holes.

By providing a pair of gas exhaust conduits each having a different gas extraction profile, due to their differing arrangement of holes, a total gas extraction profile for the pair can be tuned by controlling a relative flow rate of gas through one of the gas exhaust conduits relative to the other.

The first set of holes may have a first hole diameter and the second set of holes may have a second hole diameter, and the first hole diameter may be different to the second hole diameter.

The holes in the first set of holes may each have the same first hole diameter.

The holes in the second set of holes may each have the same second hole diameter.

The first hole diameter may increase towards the first end of the first gas exhaust conduit and the second hole diameter may decrease towards the first end of the second gas exhaust conduit.

Adjacent holes in the first set of holes may have different diameters.

The first hole diameter may increases every two holes in the first set of holes.

Adjacent holes in the second set of holes may have different diameters.

The second hole diameter may increase every two holes in the second set of holes.

Each increase or decrease in hole diameter may be of the same magnitude.

The first set of holes may have a first hole spacing and the second set of holes may have a second hole spacing, wherein the first hole spacing is different to the second hole spacing.

The first hole spacing may decrease towards the first end of the first gas exhaust conduit and the second hole spacing may decrease towards the second end of the second gas exhaust conduit.

As measured in a plane perpendicular to the first direction, the first gas exhaust conduit and the second gas exhaust conduit may each have a length in a second direction perpendicular to the first direction and a width in a third direction perpendicular to the first direction and the second direction, the length being greater than the width. The length may be at least 1.5 times the width, preferably at least 2 times the width.

The gas conduction channels may each have a cross-section in a plane perpendicular to the first direction having a rounded rectangular shape.

This elongated form of the cross-section of the gas exhaust conduits may allow for a better fit inside a process chamber of a vertical furnace, for example by aligning the gas exhaust conduits in a circumferential direction of the process chamber, while still providing a relatively large inner volume of the gas exhaust conduits.

The first set of holes may be formed in a part of the first gas exhaust conduit wall which extends in the third direction and the second set of holes may be formed in a part of the second gas exhaust conduit wall which extends in the third direction. By positioning the first and second set of holes in this way, the first gas exhaust conduit and the second gas exhaust conduit may be positioned in a process chamber of a vertical furnace with the first set of holes facing the second set of holes along a circumferential direction. This may help to provide a horizontally symmetric gas flow profile in the process chamber and to prevent local dead spots in the gas flow.

The gas exhaust conduits may be made of silicon, quartz, or silicon carbide.

The gas conduction channels may each have a cross-sectional area of at least 1000mm² in a plane perpendicular to the first direction.

The gas conduction channels may each have a cross-sectional area of at least 2000mm² in a plane perpendicular to the first direction.

The first set of holes and the second set of holes may be distributed over at least 50% of a length of the respective conduit.

Each of the first set of holes and the second set of holes may include at least ten holes. That is, the first set of holes may include at least ten holes and the second set of holes may include at least ten holes.

Each of the first set of holes and the second set of holes may include at least twenty holes. That is, the first set of holes may include at least twenty holes and the second set of holes may include at least twenty holes.

Each of the first set of holes and the second set of holes may include at least 50 holes, at least 75 holes, at least 100 holes, at least 120 holes, or at least 150 holes. The first set of holes and the second set of holes may each include one hole per wafer to be treated in a semiconductor processing apparatus which comprises the gas exhaust conduit pair. By providing one hole per wafer, gas flow across the process chamber from gas injector to gas exhaust conduit may be made more uniform. The first set of holes and the second set of holes may together include one hole per wafer to be treated in a semiconductor processing apparatus which comprises the gas exhaust conduit pair. For example, if 150 wafers are to be treated, the first set of holes may consist of 75 holes and the second set of holes may consist of 75 holes.

A smallest hole in the first set of holes and the second set of holes may have a diameter of at least 1mm.

A largest hole in the first set of holes and the second set of holes may have a diameter of no more than 15mm.

An average hole size of the first set of holes and an average hole size of the second set of holes may each be less than 7mm.

The first gas exhaust conduit may be tapered along the first direction such that the cross-sectional area of the first gas exhaust conduit at the second end is smaller than the cross-sectional area of the first gas exhaust conduit at the first end. The second gas exhaust conduit may be tapered along the first direction such that the cross-sectional area of the second gas exhaust conduit at the second end is smaller than the cross-sectional area of the second gas exhaust conduit at the first end, the cross-sectional areas being taken in a plane perpendicular to the first direction.

The taper provides an increase in cross-sectional area of the gas conduction channels from the top (second) end to the bottom (first) end. This may help to reduce pressure drop along the gas exhaust conduit, as more flow enters the conduit from top to bottom. As a consequence, this also means that larger holes in the gas exhaust conduit can be used, which further allows for a reduction in the net pressure drop of the gas exhaust conduit.

The first gas exhaust conduit may be configured to preferentially extract gas from an upper region of a process chamber and the second gas exhaust conduit may be configured to preferentially extract gas from a lower region of the process chamber.

According to a second aspect of the present invention there is provided a semiconductor processing apparatus comprising a process chamber configured to receive a plurality of substrates supported by a substrate boat; at least one gas injector for providing a gas to the process chamber; at least two gas exhaust outlets for removing a gas from the process chamber; and a gas exhaust conduit pair according to the first aspect, each gas exhaust conduit in the gas exhaust conduit pair being connected to a respective gas exhaust outlet, wherein each of the gas exhaust conduits extends in a vertical direction inside the process chamber over at least part of the substrate boat

By providing at least two gas exhaust conduits, each connected to a respective gas exhaust outlet, individual control over gas exhaust paths is provided. By providing at least two gas exhaust conduits having different gas extraction profiles along the vertical direction, a total gas extraction profile for the process chamber can be controlled by controlling the amount of gas exhausted via each gas exhaust conduit. This allows the gas extraction profile to be matched to a gas injection profile to the process chamber, which allows for a more uniform gas flow in the process chamber. A more uniform gas flow results in less variability in the amount of precursor deposited on the plurality of substrates.

Other technical features may be readily apparent to one skilled in the art from the following figures, descriptions, and claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE DRAWINGS

Certain embodiments of the present invention will now be described, by way of example, with reference to the accompanying drawings, in which:
FIG. 1 is a schematic cross-sectional view of a semiconductor processing apparatus according to embodiments of the present invention;
FIG. 2 is a schematic perspective view of a gas exhaust conduit pair according to an embodiment of the present invention.
FIG. 3 is a schematic perspective view of a gas exhaust conduit pair according to a further embodiment of the present invention.
FIG. 4 is a schematic perspective view of a gas exhaust conduit pair according to a further embodiment of the present invention.
FIG. 5 is a schematic perspective view of a gas exhaust conduit pair according to a further embodiment of the present invention.
FIG. 6 is a cross-sectional view of a gas exhaust conduit comprised in a gas exhaust conduit pair according to embodiments of the present invention.
FIG. 7 is a schematic perspective view of a gas exhaust conduit pair according to a further embodiment of the present invention.
FIG. 8 is a schematic perspective view of a gas exhaust conduit pair according to a further embodiment of the present invention.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

The description of exemplary embodiments of methods and compositions provided below is merely exemplary and is intended for purposes of illustration only. The following description is not intended to limit the scope of the disclosure or the claims. Moreover, recitation of multiple embodiments having indicated features or steps is not intended to exclude other embodiments having additional features or steps or other embodiments incorporating different combinations of the stated features or steps.

Where in the present disclosure two or more elements are referred to as being "in fluid communication", it is meant that a fluid such as a gas or liquid or mixture thereof can flow between the elements, in one or both directions. The fluid communication may be achieved, for example, by means of a gas line, tube, pipe, inlet, outlet, or any combination thereof. The fluid communication may be interruptible; for example, a valve or other flow control element may be present.

In this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, etc. in some embodiments. Further, in this disclosure, the terms "including," "constituted by" and "having" can refer independently to "typically or broadly comprising," "comprising," "consisting essentially of," or "consisting of" in some embodiments. In this disclosure, any defined meanings do not necessarily exclude ordinary and customary meanings in some embodiments. In some cases, percentages indicate herein can be relative or absolute percentages.

A number of example materials are given throughout the embodiments of the current disclosure, it should be noted that the chemical formulas given for each of the example materials should not be construed as limiting and that the non-limiting example materials given should not be limited by a given example stoichiometry.

In the specification, it will be understood that the term "on" or "over" may be used to describe a relative location relationship. Another element, film or layer may be directly on a mentioned layer, or another layer (an intermediate layer) or element may be intervened therebetween, or a layer may be disposed on a mentioned layer but not completely cover a surface of the mentioned layer. Therefore, unless the term "directly" is separately used, the term "on" or "over" will be construed to be a relative concept. Similarly to this, it will be understood the term "under", "underlying", or "below" will be construed to be relative concepts.

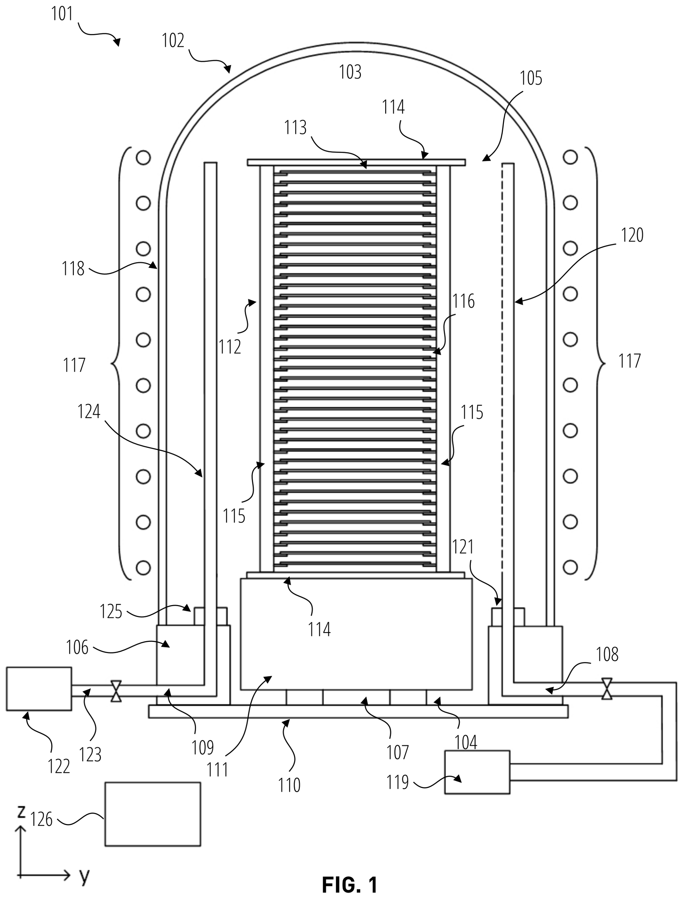

Referring to FIG. 1, a semiconductor processing apparatus 101 according to embodiments of the present invention is shown. The semiconductor processing apparatus 101 comprises a process chamber 102 which is generally bell jar shaped, having a closed top end 103, a closable bottom end 104, and an interior space 105. The semiconductor processing apparatus 101 may be a vertical furnace and the process chamber 102 may accordingly extend along a first direction z between the top end 103 and the bottom end 104. The semiconductor processing apparatus 101 may comprise a flange assembly 106 for at least partially supporting the process chamber 102 at the bottom end 104. The flange assembly 106 may be generally circular in shape as viewed along the vertical direction. The flange assembly 106 may comprise a central opening 107 and various gas inlets 108 and gas outlets 109 for providing or removing a gas from the interior space 105 respectively. The flange assembly 106 may be configured to partially close off the bottom end 104 of the process chamber 102.

The semiconductor processing apparatus 101 comprises a doorplate 110 configured to at least partially close off the bottom end 104 of the process chamber 102. The doorplate 110 may support a pedestal 111 thereon. The pedestal 111 may be configured to support a substrate carrier 112, also referred to as a boat. In some embodiments, no pedestal may be provided and the substrate carrier 112 may be supported directly on the doorplate 110. The pedestal 111 (if included) and boat may be inserted into and removed from the process chamber 102 through the bottom end 104 by moving the doorplate 110 in a vertical direction.

The substrate carrier 112 is configured to support a plurality of substrates 113 therein. The plurality of substrates 113 may be spaced apart in a vertical direction with a separation d. The substrate carrier 112 may comprise two end plates 114 spaced apart by a plurality of support rods 115. The plurality of support rods 115 may comprise a plurality of sets of slots 116 or projections for supporting the plurality of substrates, each set of slots 116 or projections being spaced apart from the other sets of slots 116 or projections in the vertical direction. Each set of slots 116 or projections being at a same vertical position forms a respective substrate receiving position.

The semiconductor processing apparatus 101 may comprise a heater for heating the process chamber 102 and thereby heating the interior space, for example in the form of heating coils 117 disposed around an outer surface 118 of the process chamber 102.

The semiconductor processing apparatus 101 comprises at least one gas inlet 108 in the flange assembly 106 for providing a gas or gases to the interior space 105 of the process chamber 102. The at least one gas inlet 108 may each be connected to one or more respective gas sources 119. The gas sources 119 may include process gas sources and purge gas sources. The gas inlets 108 may be categorised according to the type of gas to be provided therethrough; for example, the flange assembly 106 may comprise one or more process gas inlets and one or more purge gas inlets.

The semiconductor processing apparatus 101 comprises at least one injector 120, each in fluid communication with a respective gas inlet 108. The semiconductor processing apparatus 101 may comprise the same number of injectors 120 as gas inlets 108, or may comprise fewer injectors 120 than gas inlets 108, that is, one or more gas inlets 108 may not be connected to an injector 120. The injector 120 or each of the injectors 120 extends in a vertical direction within the process chamber 102. The injector 120 or each of the injectors 120 may be supported at a bottom end by an injector holder 121 which may be removably attached to the flange assembly 106. In some embodiments, the semiconductor processing apparatus 101 comprises at least one multi-hole injector and at least one dump injector.

The semiconductor processing apparatus 101 comprises a plurality of gas outlets 109 in the flange assembly 106 for removing a gas or gases from the interior space 105 of the process chamber 102. The plurality of gas outlets 109 may each be in fluid communication with a vacuum pump 122 via respective exhaust gas lines 123. The semiconductor processing apparatus 101 comprises at least two gas exhaust conduits 124, for example two gas exhaust conduits forming a gas exhaust conduit pair as described hereinafter in further detail, each gas exhaust conduit 124 being in fluid communication with a respective gas outlet 109. Each of the gas exhaust conduits 124 may be supported at a bottom end by a gas exhaust conduit holder 125 which may be removably attached to the flange assembly 106. Each of the gas exhaust conduits 124 extends in a vertical direction inside the process chamber 102 and may comprise a plurality of holes spaced apart in the vertical direction. In some embodiments, each of the gas exhaust conduits 124 may be oriented such that the plurality of holes faces towards the substrate carrier 112. In some embodiments, each of the gas exhaust conduits 124 may be oriented such that the plurality of holes face in a circumferential direction. In some embodiments, each of the gas exhaust conduits 124 may be oriented such that the plurality of holes in one of the gas exhaust conduits faces the plurality of holes in the other gas exhaust conduit. The semiconductor processing apparatus 101 may comprise the same number of gas exhaust conduits 124 as gas outlets 109, or may comprise fewer gas exhaust conduits 124 than gas outlets 109, that is, one or more gas outlets 109 may not be connected to a gas exhaust conduit 124.

The semiconductor processing apparatus 101 may comprise a controller 126 which may be configured to control various elements of the semiconductor processing apparatus 101. The controller 126 may comprise a memory for storing, for example, program instructions, setpoint values, characterisation data, and other data. The controller 126 may comprise a processor for executing program instructions which may be loaded from the memory. The controller 126 may be configured to receive data from sensors in the semiconductor processing apparatus 101, for example pressure sensors, temperature sensors, and/or other types of sensors. The controller 126 may be configured to control elements of the semiconductor processing apparatus 101 by sending control signals to, for example, gas flow control valves, heating elements, water cooling elements.

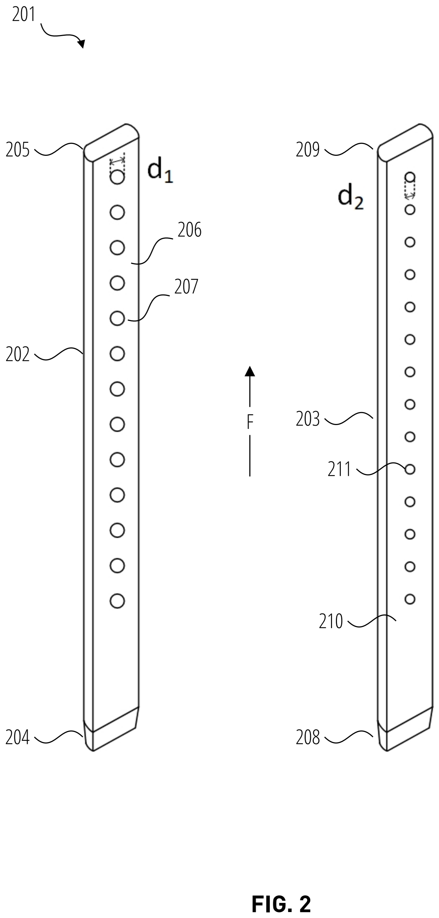

Referring to FIG. 2, a gas exhaust conduit pair 201 according to embodiments of the present invention is shown, comprising a first gas exhaust conduit 202 and a second gas exhaust conduit 203.

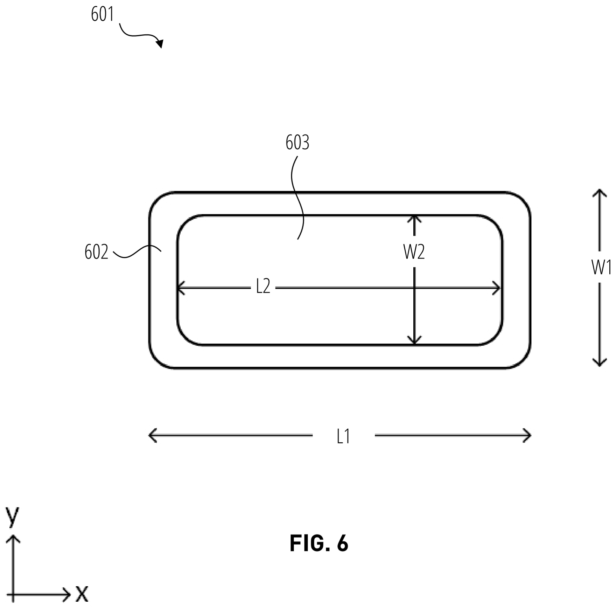

The first gas exhaust conduit 202 extends from an open bottom end 204 at which the first gas exhaust conduit 202 is connectable to a gas outlet 109, to a top, closed end 205, along a main axis F. The first gas exhaust conduit 202 comprises a first gas exhaust conduit wall 206 which defines a first gas exhaust conduit internal channel (FIG. 6) for gas conduction.

The first gas exhaust conduit 202 comprises a first set of holes 207 in the first gas exhaust conduit wall 206 such that a gas may enter the first gas exhaust conduit internal channel via the first set of holes 207. The first set of holes 207 may comprise at least ten, at least fifteen, or at least twenty holes. The holes in the first set of holes 207 are spaced apart in a direction parallel to the main axis F of the first gas exhaust conduit 202. The holes in the first set of holes 207 each have the same hole diameter d₁.

The second gas exhaust conduit 203 extends from an open bottom end 208 at which the second gas exhaust conduit 203 is connectable to a gas outlet 109, to a top, closed end 209, along a main axis F. The second gas exhaust conduit 203 comprises a second gas exhaust conduit wall 210 which defines a second gas exhaust conduit internal channel (FIG. 6) for gas conduction.

The second gas exhaust conduit 203 comprises a second set of holes 211 in the second gas exhaust conduit wall 210 such that a gas may enter the second gas exhaust conduit internal channel via the second set of holes 211. The second set of holes 211 may comprise at least ten, at least fifteen, or at least twenty holes. The holes in the second set of holes 211 are spaced apart in a direction parallel to the main axis F of the second gas exhaust conduit 203. The holes in the second set of holes 211 each have the same hole diameter d₂.

The first set of holes 207 has a different arrangement, or configuration, to the second set of holes 211. The first gas exhaust conduit 202 is not identical to the second gas exhaust conduit 203.

Due to the differing hole arrangement, in this case the differing hole diameter, the first gas exhaust conduit 202 has a different gas extraction profile to the second gas exhaust conduit 203. This allows a total gas extraction profile of the gas exhaust conduit pair 201 to be controlled by controlling a flow rate of gas through the first gas exhaust conduit 202 and the second gas exhaust conduit 203. This can allow a gas extraction profile from the process chamber 102 to be made more uniform.

The hole diameters of the first gas exhaust conduit 202 and the second gas exhaust conduit 203 may be chosen so as to achieve a particular ratio of extraction of one gas exhaust conduit relative to the other gas exhaust conduit.

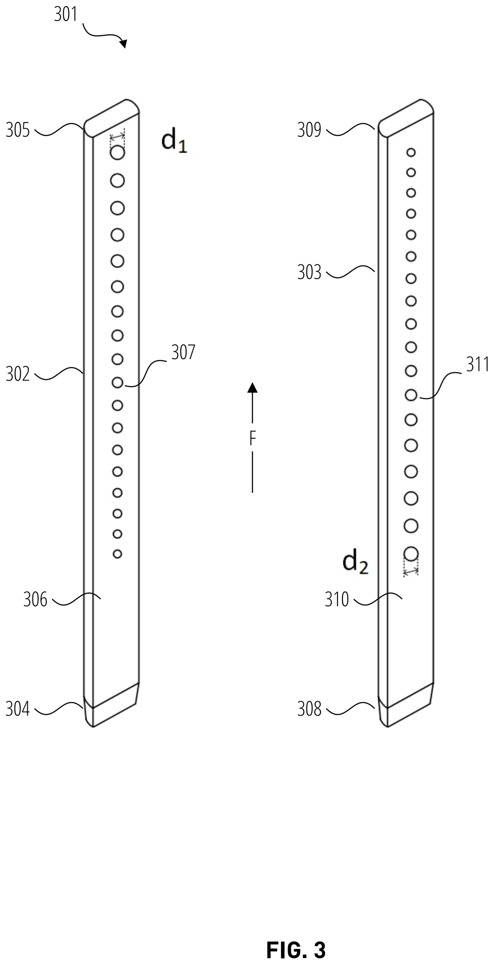

Referring to FIG. 3, a further embodiment of gas exhaust conduit pair 301 according to embodiments of the present invention is shown, comprising a first gas exhaust conduit 302 and a second gas exhaust conduit 303.

The first gas exhaust conduit 302 extends from an open bottom end 304 at which the first gas exhaust conduit 302 is connectable to a gas outlet 109, to a top, closed end 305, along a main axis F. The first gas exhaust conduit 302 comprises a first gas exhaust conduit wall 306 which defines a first gas exhaust conduit internal channel (FIG. 6) for gas conduction.

The first gas exhaust conduit 302 comprises a first set of holes 307 in the first gas exhaust conduit wall 306 such that a gas may enter the first gas exhaust conduit internal channel via the first set of holes 307. The first set of holes 307 may comprise at least ten, at least fifteen, or at least twenty holes. The holes in the first set of holes 307 are spaced apart in a direction parallel to the main axis F of the first gas exhaust conduit 302.

The first set of holes 307 have a hole diameter d₁ which increases towards the top end 305 of the first gas exhaust conduit 302. The hole diameter d₁ may be different for each of the holes in the first set of holes 307, that is, the hole diameter d₁ may increase by an increment from one hole to an adjacent hole. The increment may be the same along the length of the first set of holes 307 or may vary. The hole diameter d₁ may increase every two holes or every three holes or every four holes. The distance between the centres of two adjacent holes may be constant along the axis of the first gas exhaust conduit 302 or may vary. By having larger diameter holes towards the top end 305 of the first gas exhaust conduit 302 and smaller diameter holes towards the bottom end 304 of the first gas exhaust conduit 302, allowing relatively more gas to enter the first gas exhaust conduit 302 in the region of the first gas exhaust conduit 302 containing larger holes and relatively less in the region of the first gas exhaust conduit 302 containing smaller holes, the first gas exhaust conduit 302 is configured to preferentially extract gas from an upper region of the process chamber 102 as compared with a lower region of the process chamber 102.

The second gas exhaust conduit 303 extends from an open bottom end 308 at which the second gas exhaust conduit 303 is connectable to a gas outlet 109, to a top, closed end 309, along a main axis F. The second gas exhaust conduit 303 comprises a second gas exhaust conduit wall 310 which defines a second gas exhaust conduit internal channel (FIG. 6) for gas conduction.

The second gas exhaust conduit 303 comprises a second set of holes 311 in the second gas exhaust conduit wall 310 such that a gas may enter the second gas exhaust conduit internal channel via the second set of holes 307. The second set of holes 311 may comprise at least ten, at least fifteen, or at least twenty holes. The holes in the second set of holes 311 are spaced apart in a direction parallel to the main axis F of the second gas exhaust conduit 303.

The second set of holes 311 have a hole diameter d₂ which increases towards the top end 309 of the second gas exhaust conduit 303. The hole diameter d₂ may be different for each of the holes in the second set of holes 311 , that is, the hole diameter d₂ may increase by an increment from one hole to an adjacent hole. The increment may be the same along the length of the second set of holes or may vary. The hole diameter d₂ may increase every two holes or every three holes or every four holes. The distance between the centres of two adjacent holes may be constant along the axis of the second gas exhaust conduit 303 or may vary. By having smaller diameter holes towards the top end 309 of the second gas exhaust conduit 303 and larger diameter holes towards the bottom end 308 of the second gas exhaust conduit 303, allowing relatively more gas to enter the second gas exhaust conduit 303 in the region of the second gas exhaust conduit 303 containing larger holes and relatively less in the region of the second gas exhaust conduit 303 containing smaller holes, the second gas exhaust conduit 303 is configured to preferentially extract gas from a lower region of the process chamber 102 as compared with an upper region of the process chamber 102.

The first set of holes 307 has a different arrangement, or configuration, to the second set of holes 311. The first gas exhaust conduit 302 is not identical to the second gas exhaust conduit 303.

Due to the differing hole arrangement, in this case differing hole diameter profile, the first gas exhaust conduit 302 has a different gas extraction profile to the second gas exhaust conduit 303. The first gas exhaust conduit 302 may preferentially extract gas towards the top end 103 of the process chamber 102 as compared with the bottom end 104 of the process chamber 102. The second gas exhaust conduit 303 may preferentially extract gas towards the bottom end 104 of the process chamber 102 as compared with the top end 103 of the process chamber 102. This allows a total gas extraction profile of the gas exhaust conduit pair 301 to be controlled by controlling a flow rate of gas through the first gas exhaust conduit 302 and the second gas exhaust conduit 303. This can allow a gas extraction profile from the process chamber 102 to be made more uniform. For example, if a process gas in the process chamber 102 tends to flow towards the bottom end of the process chamber 102, a gas flow rate through the first gas exhaust conduit 302 can be set to a higher value than a gas flow rate through the second gas exhaust conduit 303, so as to extract more gas towards the top of the process chamber 102 compared to the bottom of the process chamber 102.

The hole diameters of the first gas exhaust conduit 302 and the second gas exhaust conduit 303 may be chosen so as to achieve a particular ratio of extraction of one gas exhaust conduit relative to the other gas exhaust conduit.

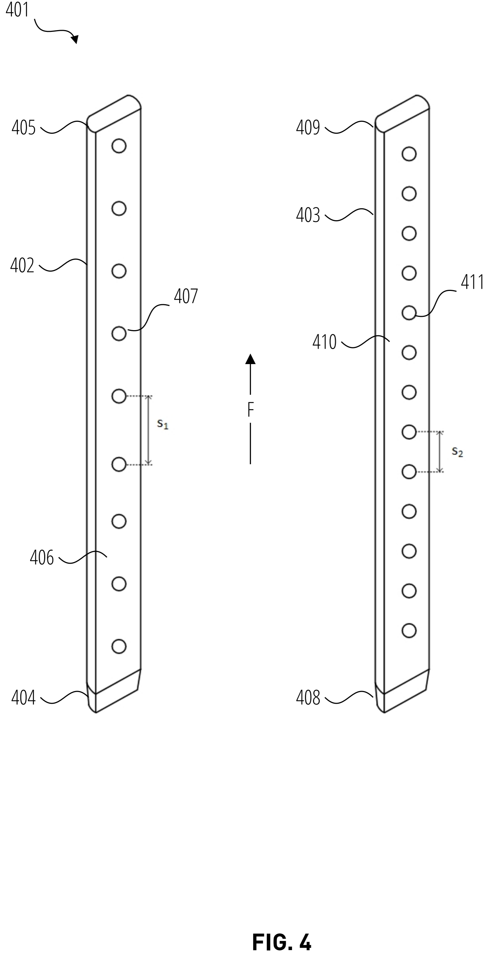

Referring to FIG. 4, a gas exhaust conduit pair 401 according to embodiments of the present invention is shown, comprising a first gas exhaust conduit 402 and a second gas exhaust conduit 403.

The first gas exhaust conduit 402 extends from an open bottom end 404 at which the first gas exhaust conduit 402 is connectable to a gas outlet 109, to a top, closed end 405, along a main axis F. The first gas exhaust conduit 402 comprises a first gas exhaust conduit wall 406 which defines a first gas exhaust conduit internal channel (FIG. 6) for gas conduction.

The first gas exhaust conduit 402 comprises a first set of holes 407 in the first gas exhaust conduit wall 406 such that a gas may enter the first gas exhaust conduit internal channel via the first set of holes 407. The first set of holes 407 may comprise at least ten, at least fifteen, or at least twenty holes. The holes in the first set of holes 407 are spaced apart in a direction parallel to the main axis F of the first gas exhaust conduit 402. The holes in the first set of holes 407 each have the same hole diameter. The holes in the first set of holes 407 have a constant hole spacing s₁.

The second gas exhaust conduit 403 extends from an open bottom end 408 at which the second gas exhaust conduit 403 is connectable to a gas outlet 109, to a top, closed end 409, along a main axis F. The second gas exhaust conduit 403 comprises a second gas exhaust conduit wall 410 which defines a second gas exhaust conduit internal channel (FIG. 6) for gas conduction.

The second gas exhaust conduit 403 comprises a second set of holes 411 in the second gas exhaust conduit wall 410 such that a gas may enter the second gas exhaust conduit internal channel via the second set of holes 411. The second set of holes 411 may comprise at least ten, at least fifteen, or at least twenty holes. The holes in the second set of holes 411 are spaced apart in a direction parallel to the main axis F of the second gas exhaust conduit 403. The holes in the second set of holes 411 each have the same hole diameter d₂.The holes in the second set of holes 411 have a constant hole spacing s₂, which is different to the hole spacing s₁ of the first set of holes 407.

The first set of holes 407 has a different arrangement, or configuration, to the second set of holes 411. The first gas exhaust conduit 402 is not identical to the second gas exhaust conduit 403.

Due to the differing hole arrangement, in this case differing hole spacing, the first gas exhaust conduit 402 has a different gas extraction profile to the second gas exhaust conduit 403. This allows a total gas extraction profile of the gas exhaust conduit pair 401 to be controlled by controlling a flow rate of gas through the first gas exhaust conduit 402 and the second gas exhaust conduit 403. This can allow a gas extraction profile from the process chamber 102 to be made more uniform.

The hole spacings of the first gas exhaust conduit 402 and the second gas exhaust conduit 403 may be chosen so as to achieve a particular ratio of extraction of one gas exhaust conduit relative to the other gas exhaust conduit.

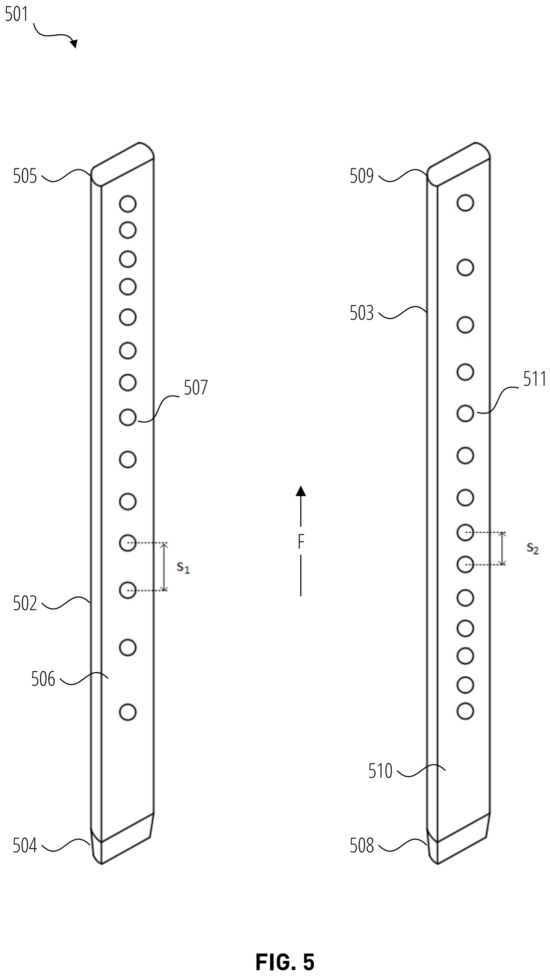

Referring to FIG. 5, a further embodiment of gas exhaust conduit pair 501 according to embodiments of the present invention is shown, comprising a first gas exhaust conduit 502 and a second gas exhaust conduit 503.

The first gas exhaust conduit 502 extends from an open bottom end 504 at which the first gas exhaust conduit 502 is connectable to a gas outlet 109, to a top, closed end 505, along a main axis F. The first gas exhaust conduit 502 comprises a first gas exhaust conduit wall 506 which defines a first gas exhaust conduit internal channel (FIG. 6) for gas conduction.

The first gas exhaust conduit 502 comprises a first set of holes 507 in the first gas exhaust conduit wall 506 such that a gas may enter the first gas exhaust conduit internal channel via the first set of holes 507. The first set of holes 507 may comprise at least ten, at least fifteen, or at least twenty holes. The holes in the first set of holes 507 are spaced apart in a direction parallel to the main axis F of the first gas exhaust conduit 502.

The first set of holes 507 have a hole spacing s₁ , being the distance between the centres of adjacent holes, which decreases towards the top end 505 of the first gas exhaust conduit 502. The hole spacing s₁ may be different for each adjacent pair of holes in the first set of holes 507, that is, the hole spacing between a first hole and a second hole adjacent to the first hole may increase by an increment compared with the hole spacing between the second hole and a third hole adjacent to the second hole and on the opposite side of the second hole to the first hole. The increment may be the same along the length of the first set of holes 507 or may vary. The hole spacing s₁ may increase every two adjacent pairs of holes or every three or four adjacent pairs of holes. By having a larger hole density towards the top end 505 of the first gas exhaust conduit 502 and smaller hole density towards the bottom end 504 of the first gas exhaust conduit 502, allowing relatively more gas to enter the first gas exhaust conduit 502 in the region of the first gas exhaust conduit 502 having a larger hole density and relatively less in the region of the first gas exhaust conduit 502 having a smaller hole density, the first gas exhaust conduit 502 is configured to preferentially extract gas from an upper region of the process chamber 102 as compared with a lower region of the process chamber 102.

The second gas exhaust conduit 503 extends from an open bottom end 508 at which the second gas exhaust conduit 503 is connectable to a gas outlet 109, to a top, closed end 509, along a main axis F. The second gas exhaust conduit 503 comprises a second gas exhaust conduit wall 510 which defines a second gas exhaust conduit internal channel (FIG. 6) for gas conduction.

The second gas exhaust conduit 503 comprises a second set of holes 511 in the second gas exhaust conduit wall 510 such that a gas may enter the second gas exhaust conduit internal channel via the second set of holes 507. The second set of holes 511 may comprise at least ten, at least fifteen, or at least twenty holes. The holes in the second set of holes 511 are spaced apart in a direction parallel to the main axis F of the second gas exhaust conduit 503.

The second set of holes 511 have a hole spacing s₂ which increases towards the top end 509 of the second gas exhaust conduit 503. The hole spacing s₂ may be different for each adjacent pair of holes in the second set of holes 511, that is, the hole spacing between a first hole and a second hole adjacent to the first hole may increase by an increment compared with the hole spacing between the second hole and a third hole adjacent to the second hole and on the opposite side of the second hole to the first hole. The increment may be the same along the second set of holes 511 or may vary. The hole spacing s₂ may increase every two adjacent pairs of holes or every three or four adjacent pairs of holes. By having a smaller hole density towards the top end 509 of the second gas exhaust conduit 503 and a larger hole density towards the bottom end 508 of the second gas exhaust conduit 503, allowing relatively more gas to enter the second gas exhaust conduit 503 in the region of the second gas exhaust conduit 503 having a larger hole density and relatively less in the region of the second gas exhaust conduit 503 having a smaller hole density, the second gas exhaust conduit 503 is configured to preferentially extract gas from a lower region of the process chamber 102 as compared with an upper region of the process chamber 102.

The first set of holes 507 has a different arrangement, or configuration, to the second set of holes 511. The first gas exhaust conduit 502 is not identical to the second gas exhaust conduit 503.

Due to the differing hole arrangement, in this case differing hole diameter profile, the first gas exhaust conduit 502 has a different gas extraction profile to the second gas exhaust conduit 503. The first gas exhaust conduit 502 may preferentially extract gas towards the top end 103 of the process chamber 102 as compared with the bottom end 104 of the process chamber 102. The second gas exhaust conduit 503 may preferentially extract gas towards the bottom end 104 of the process chamber 102 as compared with the top end 103 of the process chamber 102. This allows a total gas extraction profile of the gas exhaust conduit pair 501 to be controlled by controlling a flow rate of gas through the first gas exhaust conduit 502 and the second gas exhaust conduit 503. This can allow a gas extraction profile from the process chamber 102 to be made more uniform. For example, if a process gas in the process chamber 102 tends to flow towards the bottom end of the process chamber 102, a gas flow rate through the first gas exhaust conduit 502 can be set to a higher value than a gas flow rate through the second gas exhaust conduit 503, so as to extract more gas towards the top of the process chamber 102 compared to the bottom of the process chamber 102.

The hole spacing variation of the first gas exhaust conduit 502 and the second gas exhaust conduit 503 may be chosen so as to achieve a particular ratio of extraction of one gas exhaust conduit relative to the other gas exhaust conduit.

Referring to FIG. 6, a cross-section of a gas exhaust conduit 601 in a plane perpendicular to the main axis F is shown. The gas exhaust conduit 601 may be comprised in a gas exhaust conduit pair according to embodiments of the present invention, and may be for example any of the first gas exhaust conduits and second gas exhaust conduits described herein. The gas exhaust conduit 601 has a gas exhaust conduit wall 602 which encloses a gas exhaust conduit internal conduction channel gas exhaust conduit internal conduction channel 603. The gas exhaust conduit internal conduction channel gas exhaust conduit internal conduction channel 603 has a cross-sectional area of at least 1000mm², preferably at least 1500mm², still more preferably at least 2000mm². By providing a large cross-sectional area, the volume of the gas exhaust conduit internal conduction channel is made large, which allows for a high gas flow rate through the gas exhaust conduit 601, even when the process chamber 102 is at low pressure.

The first gas exhaust conduit and the second gas exhaust conduit may each have a length L1 in a second direction x perpendicular to the first direction. The first gas exhaust conduit and the second gas exhaust conduit may each have a width W1 in a third direction perpendicular to the first direction and the second direction. The length L1 may be greater than the width W1. For example, the length L1 may be at least 1.5, at least 2, or at least 2.5 times the width W1.

The gas exhaust conduit internal conduction channel 603 may have a length L2 in the second direction x which is perpendicular to the first direction. The gas exhaust conduit internal conduction channel 603 may have a width W2 in the third direction which is perpendicular to the first direction and the second direction. The length L2 may be greater than the width W2. For example, the length L2 may be at least 1.5, at least 2, or at least 2.5 times the width W2. By providing a gas exhaust conduit with an elongated shape in the cross-section, a better fit into the process chamber 102 may be provided, as the gas exhaust conduits may be aligned with their longer sides, that is, those which extend in the second direction, being positioned along a circumferential direction inside the process chamber 102.

The gas exhaust conduit internal conduction channel 603 may have a rounded rectangular shape in a plane perpendicular to the main axis F. The gas exhaust conduit 601 may have a rounded rectangular outer profile in the same plane. The wall thickness of the gas exhaust conduit wall 602 may be substantially constant in a plane perpendicular to the main axis F.

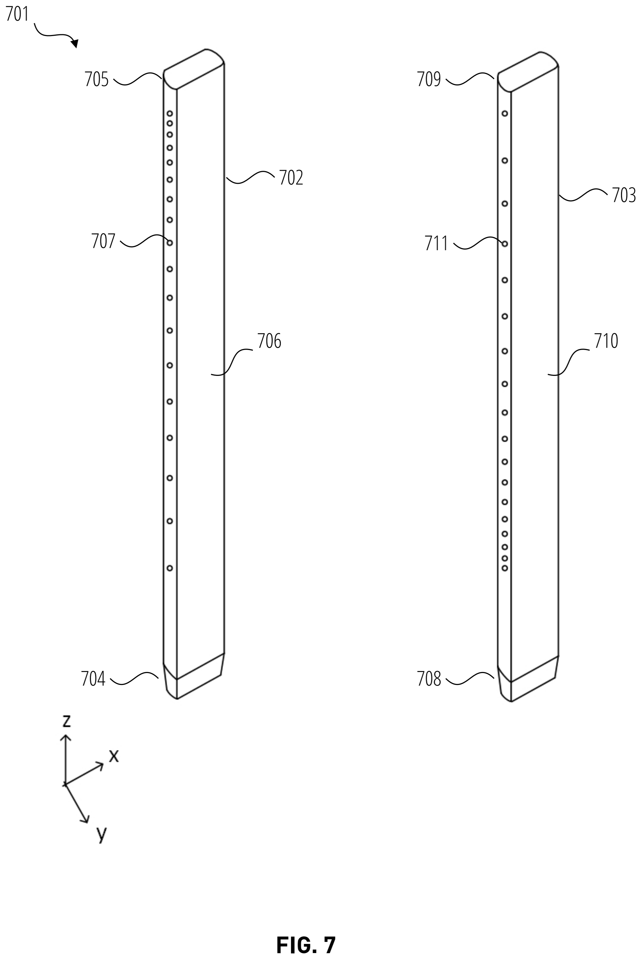

Referring to FIG. 7, a further embodiment of gas exhaust conduit pair 701 according to embodiments of the present invention is shown, comprising a first gas exhaust conduit 702 and a second gas exhaust conduit 703.

The first gas exhaust conduit 702 extends from an open bottom end 704 at which the first gas exhaust conduit 702 is connectable to a gas outlet 109, to a top, closed end 705, along a main axis F. The first gas exhaust conduit 702 comprises a first gas exhaust conduit wall 706 which defines a first gas exhaust conduit internal channel (FIG. 6) for gas conduction.

The first gas exhaust conduit 702 comprises a first set of holes 707 in the first gas exhaust conduit wall 706 such that a gas may enter the first gas exhaust conduit internal channel via the first set of holes 707. The first set of holes 707 may comprise at least ten, at least fifteen, or at least twenty holes. The holes in the first set of holes 707 are spaced apart in a direction parallel to the main axis F of the first gas exhaust conduit 707.

The second gas exhaust conduit 703 extends from an open bottom end 708 at which the second gas exhaust conduit 703 is connectable to a gas outlet 109, to a top, closed end 709, along a main axis F. The second gas exhaust conduit 703 comprises a second gas exhaust conduit wall 710 which defines a second gas exhaust conduit internal channel (FIG. 6) for gas conduction.

The second gas exhaust conduit 703 comprises a set of holes 711 in the second gas exhaust conduit wall 710 such that a gas may enter the second gas exhaust conduit internal channel via the second set of holes 711 . The second set of holes 711 may comprise at least ten, at least fifteen, or at least twenty holes. The holes in the second set of holes 711 are spaced apart in a direction parallel to the main axis F of the second gas exhaust conduit 703.

The first set of holes 707 and the second set of holes 711 may have any of the configurations described herein such that the first set of holes 707 has a different arrangement to the second set of holes 711.

The first set of holes 707 may be formed in a part of the first gas exhaust conduit wall 706 which extends in the third direction. The second set of holes 711 may be formed in a part of the second gas exhaust conduit wall 710 which extends in the third direction. The cross-section of the gas exhaust conduits may have the form shown in FIG. 6 with the length being greater than the width. By positioning the first and second set of holes in this way, the first gas exhaust conduit and the second gas exhaust conduit may be positioned in a process chamber of a vertical furnace with the first set of holes facing the second set of holes along a circumferential direction. This may help to provide a horizontally symmetric gas flow profile in the process chamber and to prevent local dead spots in the gas flow.

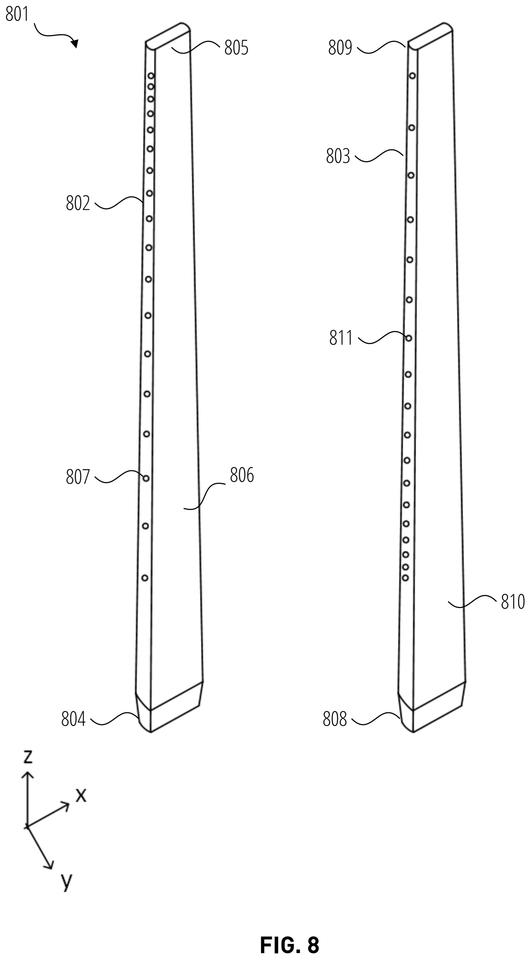

Referring to FIG. 8, a further embodiment of gas exhaust conduit pair 801 according to embodiments of the present invention is shown, comprising a first gas exhaust conduit 802 and a second gas exhaust conduit 803.

The first gas exhaust conduit 802 extends from an open bottom end 804 at which the first gas exhaust conduit 802 is connectable to a gas outlet 109, to a top, closed end 805, along a main axis F. The first gas exhaust conduit 802 comprises a first gas exhaust conduit wall 806 which defines a first gas exhaust conduit internal channel (FIG. 6) for gas conduction.

The first gas exhaust conduit 802 comprises a first set of holes 807 in the first gas exhaust conduit wall 806 such that a gas may enter the first gas exhaust conduit internal channel via the first set of holes 807. The first set of holes 807 may comprise at least ten, at least fifteen, or at least twenty holes. The holes in the first set of holes 807 are spaced apart in a direction parallel to the main axis F of the first gas exhaust conduit 807.

The second gas exhaust conduit 803 extends from an open bottom end 808 at which the second gas exhaust conduit 803 is connectable to a gas outlet 109, to a top, closed end 809, along a main axis F. The second gas exhaust conduit 803 comprises a second gas exhaust conduit wall 810 which defines a second gas exhaust conduit internal channel (FIG. 6) for gas conduction.

The second gas exhaust conduit 803 comprises a set of holes 811 in the second gas exhaust conduit wall 810 such that a gas may enter the second gas exhaust conduit internal channel via the second set of holes 811 . The second set of holes 811 may comprise at least ten, at least fifteen, or at least twenty holes. The holes in the second set of holes 811 are spaced apart in a direction parallel to the main axis F of the second gas exhaust conduit 803.

The first set of holes 807 and the second set of holes 811 may have any of the configurations described herein such that the first set of holes 807 has a different arrangement to the second set of holes 811.

The first gas exhaust conduit 802 is tapered along the first direction z (main axis F) such that the cross-sectional area of the first gas exhaust conduit 802 at the second end 805 is smaller than the cross-sectional area of the first gas exhaust conduit at the first end 804. The second gas exhaust conduit 803 is tapered along the first direction z (main axis F) such that the cross-sectional area of the second gas exhaust conduit 803 at the second end 809 is smaller than the cross-sectional area of the second gas exhaust conduit 803 at the first end 808, the cross-sectional areas being taken in a plane perpendicular to the first direction x (main axis F). The first gas exhaust conduit internal channel and the second gas exhaust conduit internal channel are tapered in the same way.

The gas exhaust conduits according to embodiments of the present invention may be made of, for example, silicon, quartz, or silicon carbide.

In some embodiments, the first set of holes 207, 307, 407, 507, 707, 807, comprises a top hole being that hole in the first set of holes which is closest to the top end 205, 305, 405, 505, 705, 805, of the first gas exhaust conduit 202, 302, 402, 502, 702, 802, and a bottom hole being that hole in the first set of holes which is closest to the bottom end 206, 306, 406, 506, 706, 806, of the first gas exhaust conduit 202, 302, 402, 502, 702, 802. The distance between the top hole and the bottom hole may be at least 50% of the distance between the top end 205, 305, 405, 505, 705, 805, and the bottom end 206, 306, 406, 506,, 706, 806. of the first gas exhaust conduit 202, 302, 402, 502, 702, 802. That is, the first set of holes may be distributed over at least 50% of the length of the first gas exhaust conduit 202, 302, 402, 502, 702, 802. The first set of holes may be distributed over at least 60% or at least 70% or at least 80% of the length of the first gas exhaust conduit 202, 302, 402, 502, 702, 802. The distance between the bottom hole and the bottom end 206, 306, 406, 506, of the first gas exhaust conduit 202, 302, 402, 502, 702, 802, may be less than 50%, less than 40%, less than 30%, less than 20%, or less than 10% of the length of the first gas exhaust conduit 202, 302, 402, 502, 702, 802.

In some embodiments, the second set of holes 211, 311, 411, 511, 711, 811 comprises a top hole being that hole in the first set of holes which is closest to the top end 209, 309, 409, 509,, 709, 809. of the second gas exhaust conduit 203, 303, 403, 503, 703, 803, and a bottom hole being that hole in the second set of holes which is closest to the bottom end 208, 308, 408, 508, 708, 808, of the second gas exhaust conduit 203, 303, 403, 503, 703, 803. The distance between the top hole and the bottom hole may be at least 50% of the distance between the top end 209, 309, 409, 509, 709, 809, and the bottom end 208, 308, 408, 508, 708, 808, of the second gas exhaust conduit second gas exhaust conduit 203, 303, 403, 503, 703, 803. That is, the second set of holes may be distributed over at least 50% of the length of the second gas exhaust conduit 203, 303, 403, 503, 703, 803. The second set of holes may be distributed over at least 60% or at least 70% or at least 80% of the length of the second gas exhaust conduit 203, 303, 403, 503, 703, 803. The distance between the bottom hole and the bottom end 208, 308, 408, 508, 708, 808, of the second gas exhaust conduit 203, 303, 403, 503, 703, 803, may be less than 50%, less than 40%, less than 30%, less than 20%, or less than 10% of the length of the second gas exhaust conduit 203, 303, 403, 503, 703, 803.

A smallest hole in the first set of holes and the second set of holes 211, 311, 411, 511, 711, 811, may have a diameter of at least 1mm, at least 2mm, at least 3mm, at least 4mm or at least 5mm. A largest hole in the first set of holes and the second set of holes 211, 311, 411, 511, 711, 811 may have a diameter of less than 15mm, less than 14mm, less than 13mm, less than 12mm, less than 11mm, less than 10mm, less than 9mm, or less than 8mm. An average hole size of the first set of holes may be less than 7mm and an average hole size of the second set of holes 211, 311, 411, 511, 711, 811, may be less than 7mm.

In some embodiments, each of the first gas exhaust conduit and the second gas exhaust conduit comprises one hole per wafer to be treated in the semiconductor processing apparatus 101. For example, the first set of holes may comprise at least 100, at least 120, or at least 150 holes. The second set of holes may comprise at least 100, at least 120, or at least 150 holes.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

## Claims

1. A gas exhaust conduit pair comprising:
a first gas exhaust conduit comprising:
a first end configured for coupling to a first gas exhaust line;
a second end opposite the first end, the second end being closed;
a first gas exhaust conduit wall extending in a first direction between the first end and the second end and enclosing a first gas conduction channel;
a first set of holes in the first gas exhaust conduit wall;
a second gas exhaust conduit comprising:
a first end configured for coupling to a second gas exhaust line;
a second end opposite the first end, the second end being closed;
a second gas exhaust conduit wall extending the first direction between the first end and the second end and enclosing a second gas conduction channel;
a second set of holes in the second gas exhaust conduit wall,
wherein the first set of holes has a different arrangement to the second set of holes.

2. The gas exhaust conduit pair of claim 1, wherein the first set of holes have a first hole diameter and the second set of holes have a second hole diameter, and wherein the first hole diameter is different to the second hole diameter.

3. The gas exhaust conduit pair of claim 1 or 2, wherein the holes in the first set of holes each have the same first hole diameter.

4. The gas exhaust conduit pair of any one of claims 1 to 3, wherein the holes in the second set of holes each have the same second hole diameter.

5. The gas exhaust conduit pair of claim 2, wherein the first hole diameter increases towards the first end of the first gas exhaust conduit and the second hole diameter decreases towards the first end of the second gas exhaust conduit.

6. The gas exhaust conduit pair of any one of claims 1 to 5, wherein the first set of holes have a first hole spacing and the second set of holes have a second hole spacing, wherein the first hole spacing is different to the second hole spacing.

7. The gas exhaust conduit pair of claim 6, wherein the first hole spacing decreases towards the first end of the first gas exhaust conduit and the second hole spacing decreases towards the second end of the second gas exhaust conduit.

8. The gas exhaust conduit pair of any one of claims 1 to 7, wherein in a plane perpendicular to the first direction, the first gas exhaust conduit and the second gas exhaust conduit each have a length in a second direction perpendicular to the first direction and a width in a third direction perpendicular to the first direction and the second direction, wherein the length is greater than the width.

9. The gas exhaust conduit pair of claim 8, wherein the length is at least 1.5 times the width.

10. The gas exhaust conduit pair of claim 8 or 9, wherein the first set of holes are formed in a part of the first gas exhaust conduit wall which extends in the third direction and the second set of holes are formed in a part of the second gas exhaust conduit wall which extends in the third direction.

11. The gas exhaust conduit pair of any one of claims 1 to 10, wherein the first gas conduction channel and the second gas conduction channel each have a cross-sectional area of at least 2000mm² in a plane perpendicular to the first direction.

12. The gas exhaust conduit pair of any one of claims 1 to 11, wherein the first set of holes and the second set of holes are distributed over at least 50% of a length of the respective conduit.

13. The gas exhaust conduit pair of any one of claims 1 to 12, wherein the first gas exhaust conduit is tapered along the first direction such that the cross-sectional area of the first gas exhaust conduit at the second end is smaller than the cross-sectional area of the first gas exhaust conduit at the first end; and wherein the second gas exhaust conduit is tapered along the first direction such that the cross-sectional area of the second gas exhaust conduit at the second end is smaller than the cross-sectional area of the second gas exhaust conduit at the first end, the cross-sectional areas being taken in a plane perpendicular to the first direction.

14. The gas exhaust conduit pair of any one of claims 1 to 13, wherein each of the first set of holes and the second set of holes includes at least ten holes.

15. The gas exhaust conduit pair of any one of claims 1 to 14, wherein each of the first set of holes and the second set of holes includes at least fifty holes.

16. The gas exhaust conduit pair of any one of claims 1 to 15, wherein a smallest hole in the first set of holes and the second set of holes has a diameter of at least 1mm.

17. The gas exhaust conduit pair of any one of claims 1 to 16, wherein a largest hole in the first set of holes and the second set of holes has a diameter of no more than 15mm.

18. The gas exhaust conduit pair of any one of claims 1 to 17, wherein an average hole size of the first set of holes and an average hole size of the second set of holes are each less than 7mm.

19. The gas exhaust conduit pair of any one of claims 1 to 18, wherein the first gas exhaust conduit is configured to preferentially extract gas from an upper region of a process chamber and the second gas exhaust conduit is configured to preferentially extract gas from a lower region of the process chamber.

20. A semiconductor processing apparatus comprising:
a process chamber configured to receive a plurality of substrates supported by a substrate boat;
at least one gas injector for providing a gas to the process chamber;
at least two gas exhaust outlets for removing a gas from the process chamber;
a gas exhaust conduit pair of any one of claims 1 to 19, each gas exhaust conduit in the gas exhaust conduit pair being connected to a respective gas exhaust outlet;
wherein each of the gas exhaust conduits extends in a vertical direction inside the process chamber over at least part of the substrate boat.
